(19) Europäisches Patentamt
European Patent Office
Office européen des brevets

(11) Publication number: **0 444 465 A2**

(12) **EUROPEAN PATENT APPLICATION**

(21) Application number: **91101924.8**

(51) Int. Cl.5: **H01L 21/225**

(22) Date of filing: **12.02.91**

(30) Priority: **02.03.90 US 487501**

(43) Date of publication of application:
**04.09.91 Bulletin 91/36**

(84) Designated Contracting States:
**DE FR GB**

(71) Applicant: **International Business Machines Corporation**
**Old Orchard Road**
**Armonk, N.Y. 10504(US)**

(72) Inventor: **Desouza, Joel P.**
**R. Anita Garibaldi 1091/606**
**Porto Alegro R.S.(BR)**
Inventor: **Greiner, James H.**
**22 Shinglehouse Road**
**Millwood, N.Y. 10546(US)**
Inventor: **Sadana, Devendra K.**
**90 Sky Top Drive**
**Pleasantville, N.Y. 10570(US)**

(74) Representative: **Gaugel, Heinz, Dipl.-Ing.**
**IBM Deutschland GmbH Schönaicher Strasse 220**
**W-7030 Böblingen(DE)**

(54) **Controlled silicon doping of III-V compounds by thermal oxidation of silicon capping layer.**

(57) The method for silicon doping of III-V compounds by depositing a layer of silicon (12) on the surface of a III-V compound substrate (10) and subjecting the silicon capped substrate (10) to thermal oxidation at temperatures and in an oxidizing atmosphere sufficient to cause silicon to diffuse into the substrate (10). A subsequent annealing step enhances the electrical characteristics of the diffused region (14).

FIG. 1b

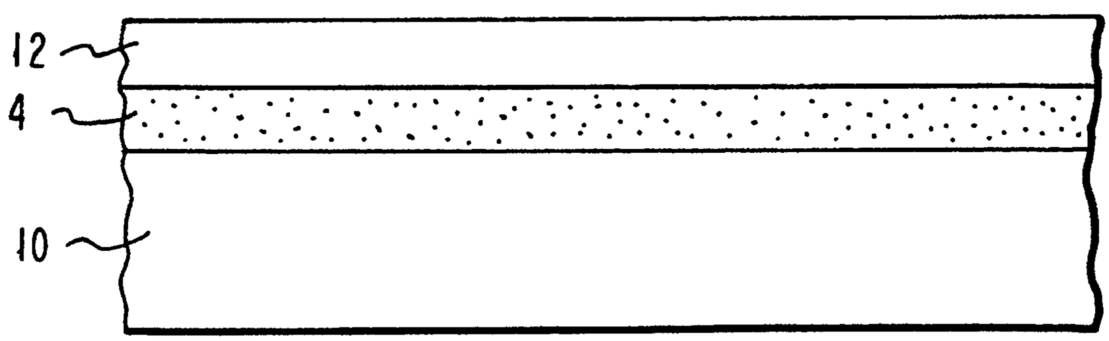


EP 0 444 465 A2

The present invention relates to doping of semiconductor III-V compounds with silicon and more particularly, to a method of silicon diffusion by thermal oxidation of a silicon capping layer.

In the fabrication of devices made from III-V compounds, such as gallium arsenide, doping is accomplished by ion implantation of the dopant elements. The control of the doping profiles in the layers of semiconductor material to obtain shallow junctions is generally achieved by implanting the dopants, such as silicon, to a predetermined depth as required to provide the desired electrical characteristics to the device. Subsequent to the step of ion implantation, it is necessary to anneal the semiconductor material to remove the damage caused by the implanted ions. Nevertheless, the damage that was produced by the ion implantation sets a limit on the electrical activation and carrier mobility in the III-V compounds. In addition, the activation efficiency typically degrades with an increasing dose of the implanted ions.

The diffusion of silicon into the III-V compounds has attracted attention as an alternative to ion implantation. Greiner et al. Appl. Phys. Lett. 44(8) 1984 disclose a method for diffusing silicon in gallium arsenide by using rapid thermal processing. The process includes depositing a layer of silicon by electron beam evaporation and subsequently depositing a layer of silicon dioxide by plasma enhanced chemical vapor deposition. Diffusion was accomplished by subsequently annealing the oxide capped silicon in a rapid thermal annealer, resulting in sheet resistances as low as 50 Ω/□ (ohms per square) and a maximum electron concentration of 5-6 x $10^{18}$ -$cm^{-3}$. No measurable diffusion was obtained by annealing uncapped layers of silicon. The use of the two different processes for depositing the silicon and for depositing the silicon dioxide cap layer presents manufacturing difficulties and may cause deficiencies in device characteristics.

The present invention is directed to a method for silicon doping of III-V semiconductor compounds by thermal oxidation of a layer of silicon deposited on the III-V material. The oxidation of the silicon capped III-V substrate causes silicon to diffuse into the underlying III-V material and at the same time causes Ga and possibly also As to diffuse out of the substrate. In addition, the silicon diffused into the III-V substrate is simultaneously activated by the thermal oxidation process. Moreover, a small amount of $O_2$ from the oxidation atmosphere diffuses into the Si layer, which may combine with silicon at the surface to form a very thin top layer of silicon dioxide. The thermal oxidation of the silicon layer results in increased electrical activation of the diffused Si and reduced sheet resistance for shallow doping regions. The sheet resistance and the depth of the silicon diffusion is controlled by the thickness of the silicon layer and the oxidation conditions. The thermal oxidation may be performed in situ with the silicon deposition thereby greatly simplifying the manufacturing process. Thus, for the first time, silicon diffusion into a III-V compound substrate can be achieved by a well controlled process without depositing a $SiO_2$ cap layer as was taught by the prior art.

In another embodiment of the method of the invention, a subsequent step of annealing the silicon capped III-V semiconductor substrate is employed to further activate the diffused silicon. The annealing step causes the resistivity of the doping region to decrease in value by a factor of 2 or more from that obtained from the thermal oxidizing step. In this embodiment, a silicon doped region of gallium arsenide has a sheet resistance of about 25 Ω/□ or greater and an electron doping concentration in the range of about $1x10^{18}$ to $1x10^{19}$ $cm^{-3}$ for shallow diffusion depths of about 0.2 $\mu$m or less.

The method of the present invention may be used to fabricate a semiconductor device on a III-V compound substrate with at least one silicon doped region having a sheet resistance less than 50 Ω/□ and an electron doping concentration greater than $6x10^{18}$ $cm^{-3}$ for depths of about 0.2 $\mu$m or less. For example, a MESFET having a gallium arsenide substrate with source and drain regions separated by a channel region all being n-doped by the inventive silicon diffusion process may be formed. Self-aligned source and drain regions can be easily fabricated by depositing the MESFET gates prior to the silicon diffusion process. Contacts to the source and drain regions may be formed by chemically cleaning the silicon layer and depositing a metal on the silicon, followed by a low temperature anneal which will provide a low resistivity contact to the underlying silicon doped regions.

The silicon diffusion process of the present invention avoids the damage caused by ion implantation and provides a simple yet powerful method to achieve shallow n-doping in III-V compounds in a controlled manner. The deposition of a $SiO_2$ cap layer is no longer a necessity. Furthermore, the thickness of the Si is not limited to 10-20 nm as in the prior art but can be greater than 200 nm.

Ways of carrying out the invention are described in detail below with reference to drawings which illustrate only specific embodiments in which:

| | |
|---|---|
| Figs. 1a and 1b | are cross-sectional views showing steps for fabricating the silicon doped regions in accordance with the method of the present invention. |
| Fig. 2 | is a set of curves of the Si atomic concentration versus the Si diffusion depth for furnace thermal oxidation. |

Fig. 3 is a set of curves of the Si atomic concentration versus the Si diffusion depth for the oxidation, and oxidation plus the subsequent annealing in accordance with another embodiment of the method of the present invention.

Fig. 4 is a set of curves of the Si atomic concentration versus the Si diffusion depth illustrating control of Si diffusion depth as well its concentration by varying the oxygen content in the rapid thermal oxidation (RTO) ambient.

Fig. 5 is a set of curves of the Si atomic concentration versus the Si diffusion depth illustrating control of Si diffusion depth as well concentration by varying the diffusion time at 950 °C for a Si cap of 50 nm and oxygen content of 1000 ppm during RTO.

Fig. 6 is a set of curves of the Si atomic concentration versus the Si diffusion depth illustrating control of Si diffusion depth as well concentration by varying the diffusion time at 1000 °C for a Si cap of 160 nm and oxygen content of 1000 ppm during RTO.

Figs. 7a - 7d show the steps of fabrication of a MESFET in accordance with the method of the present invention.

Figs. 8a - 8c show the steps of fabrication of a semiconductor device in accordance with another embodiment of the present invention.

The present invention, is directed to a method for silicon doping a semiconductor substrate of a group III-V compound such as gallium arsenide. In accordance with the method of the invention, a gallium arsenide substrate is loaded into a deposition chamber and a layer of silicon is deposited onto the substrate. Fig. 1a shows the resulting structure of a III-V semiconductor compound substrate 10, capped with a layer of silicon 12. The deposition of the silicon layer may be formed by any suitable method such as molecular beam epitaxy, chemical vapor deposition e-beam evaporation or sputtering. The thickness of the silicon cap layer is one of the factors that is used to control the depth of the silicon diffusion. Depending on the desired result, the silicon layer can be deposited from a thickness of about 10 nm to 200 nm or greater.

After the deposition of the silicon layer 12, the silicon cap layer is thermally oxidized at a temperature in the range of about 500 to 1100 °C. The thermal oxidation of the silicon causes silicon to diffuse into the substrate 10 to form diffusion region 14. The thermal oxidation step induces silicon diffusion into the underlying III-V substrate and simultaneously promotes the electrical activation of the diffused silicon. During the process, gallium and arsenic out diffuse into the silicon cap layer in an amount equal to or greater than the amount of silicon diffusing into the gallium arsenide. In addition, a small amount of $O_2$ diffuses into the silicon layer. The diffusion of oxygen into the silicon cap layer may cause a very thin layer (on the order of a few monolayers) of silicon dioxide (not shown) to form on the surface of the cap layer 12. The inventors have determined that the $SiO_2$ layer that may form is not critical to the diffusion of silicon in the inventive method. Therefore, in contrast to the prior art teachings, the method of the present invention does not require that the silicon layer be capped with $SiO_2$ for silicon diffusion to occur.

An alternate embodiment is shown in Fig. 1c in which a diffusion barrier layer 18 of silicon nitride or aluminum oxide is interposed between the substrate 10 and the silicon layer 12 prior to the thermal oxidation. The barrier layer 18 will typically be in the range of about 10 to 20 nm. The barrier layer 18 acts to prevent the out diffusion of gallium, arsenic or other group III and V elements into the silicon layer during the thermal oxidation step. In a further option, shown in Fig. 1d, phosphorus, arsenic or boron doping is added to the deposited silicon prior to oxidation. The dopant, typically at high concentrations, will enhance the rate of silicon doping of the substrate that is achieved by the subsequent thermal oxidation step.

The thermal oxidation may be performed by a conventional furnace process or by a rapid thermal oxidation (RTO) process. The difference between the furnace and RTO processes is that the furnace process is limited to a temperature of 850° or less, while in the RTO process, temperatures of 1000 °C or greater can be achieved. The oxidizing ambient may be pure oxygen, dry air, steam, or a diluted oxidation ambient. The diluted oxidation ambient may be from 200 ppm oxygen mixed with argon or greater. The rapid thermal oxidation process in a diluted oxidation ambient may be more desirable than the pure $O_2$ oxidation for certain applications as the diluted RTO process minimizes undesirable oxidation of any uncapped surface areas of the substrate as well as various metals and silicides on the substrate during the doping process.

In the subsequent annealing step, the thermally oxidized sample is subjected to an annealing treatment at temperatures of about 600 to 1100 °C in an inert ambient. The subsequently annealing step may be performed in situ, with the thermal oxidation step. The annealing treatment further activates the silicon diffused within the III-V compound and causes the resistivity of the diffused region to decrease from the value obtained when the silicon was driven by the thermal oxidation step. The sheet resistance and depth of diffusion can be further controlled by controlling the annealing conditions, in addition to controlling the silicon thickness and the oxidation conditions.

Example I

A gallium arsenide substrate was placed in a reaction chamber and a layer of silicon was deposited by e-beam evaporation. Two samples were made, one with a silicon cap layer of 50 nm thick and a second with a silicon cap layer of 160 nm thick. Subsequently, the samples were oxidized by a conventional furnace oxidation technique to diffuse silicon into the gallium arsenide. For the sample with the 50 nm silicon cap layer, the oxidation was performed at 800°C for 25 minutes. The oxidation for the sample with the 160 nm silicon cap layer was at 825°C for 15 minutes. Table I below shows the electrical data obtained from the two samples.

Table I

Furnace Oxidation Electrical Data

Oxygen Ambient: 100% Dry $O_2$

| Si Cap (nm) | Sample | Oxidat. Condit. °C/min. | Sheet Resistance (Rs) (Ω/□) | Sheet Carriers (Ns) ($cm^{-2}$) | Hall Mobility (μ) ($cm^2/Vs$) | Depth (nm) at ($1x10^{17}cm^{-3}$) of Si |
|---|---|---|---|---|---|---|
| 50 | (a) | 800/25 | 155 | $3.5x10^{13}$ | 1150 | 200 |
| 160 | (b) | 825/15 | 290 | $2.6x10^{13}$ | 825 | 270 |

Fig. 2 shows the atomic silicon concentration versus the depth of the diffused silicon for samples a and b obtained by secondary ion mass spectrometry (SIMS). As can be seen from Fig. 2, the silicon atomic concentration within 0.2 μm was in the range of about $1x10^{17}$ $cm^{-3}$ to over $1x10^{19}$ $cm^{-3}$ for sample a. The atomic concentration within 0.2 μm for sample b was in the range of about $5x10^{18}$ $cm^{-3}$ to over $1x10^{19}$ $cm^{-3}$. As can be seen from Table I, for shallow diffusion regions of about 200 nm in sample a, the sheet resistance was less than 200 Ω/□ .

Example II

A silicon cap layer was deposited on a gallium arsenide substrate in the same manner as in Example I. The silicon cap layer was then subjected to rapid thermal oxidation (RTO) procedure to cause silicon to diffuse into the gallium arsenide. Three samples were made having a silicon cap thickness of 50 nm and one sample was made having a silicon cap thickness of 160 nm. Each sample was oxidized in a dilute oxygen ambient of 1000 ppm $O_2$ in Argon. The samples were each then subjected to a subsequent anneal by a rapid thermal annealing (RTA) technique.

Fig. 3 shows the SIMS profiles for a sample that was first subjected to an RTO and subsequently subjected to an RTA. Curve c is for the RTO at 850°C for 60 seconds and curve d is after a subsequent annealing was performed by RTA at 850°C for 30 seconds. Table II below shows the electrical data at various silicon cap thickness's, and temperatures and time periods.

Table II

Two-Step Annealing (RTO and RTA) Electrical Data

Oxygen Ambient: 1000 ppm in Ar

| Cap (nm) | RTO (°C/sec) | RTA (°C/sec) | Rs (Ω/□) | Ns (cm-2) | μ (cm²/Vs (1x10$^{17}$cm$^{-3}$) of Si | Depth (nm) |
|---|---|---|---|---|---|---|
| | 850/60 | -- | 184 | $3.0x10^{13}$ | 1120 | 180 |
| | 850/60 | 850/30 | 51 | $1.1x10^{14}$ | 1145 | 220 |
| | 1000/10 | -- | 102 | $8.0x10^{13}$ | 763 | 325 |
| 50 | 1000/10 | 950/5 | 37 | $2.4x10^{14}$ | 715 | 350 |
| | 1000/20 | -- | 66 | $1.3x10^{14}$ | 743 | 600 |
| | 1000/20 | 950/5 | 30 | $3.3x10^{14}$ | 630 | 600 |
| | 850/60 | -- | 242 | $2.0x10^{13}$ | 1263 | 160 |
| 160 | 850/60 | 850/30 | 93 | $5.0x10^{13}$ | 1350 | 200 |

As can be seen from the first line of data in table II, the RTO run produced a silicon doped region of 180 nm thick with a sheet resistance of 184 Ω/□ , while the subsequent RTA produced a depth of 220 nm with a sheet resistance of 51 Ω/□ . Thus, a pronounced reduction in sheet resistance was obtained by the additional annealing treatment. The data shows that sheet resistances can be obtained, depending on the thickness of the silicon cap layer, as low as about 30 Ω/□ or greater. As can be seen from Fig. 3, the atomic concentration of silicon was between $1x10^{17}$ $cm^{-3}$ to $5x10^{19}$ $cm^{-3}$ within 0.22 $\mu$m even after the subsequent annealing step. In addition, the doping efficiency increased dramatically by a factor of about 2 to up to 3.5 by subjecting the substrate to the subsequent annealing step. Thus, in accordance with the embodiment of the invention which includes a thermal oxidation and subsequent annealing, a silicon doped region in gallium arsenide can be obtained having a resistivity of about 50 Ω/□ or less and a doping concentration of about $10^{19}$ $cm^{-3}$ values that heretofore could not be obtained by known prior art approaches.

The oxidation conditions are also a major factor that determines the depth of silicon diffusion. The oxidation conditions include the type of oxygen ambient, the amount of oxygen therein, the temperature and the length of time the process runs. By controlling the thickness of the silicon layer and the oxidation conditions, the sheet resistance and depth of diffusion can be controlled. Depending on the thickness of the deposited silicon, and the oxidation conditions, the present invention provides for silicon diffusion regions into the III-V substrate to a thickness in the range of about 10 to 200 nm or greater.

Figs. 4, 5 and 6 are atomic silicon concentration versus silicon diffusion depth curves that illustrate the type of control that may be accomplished with the inventive silicon doping method. Fig. 4 is a set of atomic Si concentration versus diffusion depth curves illustrating control of Si diffusion depth as well its concentration by varying the oxygen content in the RTO ambient. All RTOs were performed at 850° C for 60 seconds with a 50 nm thick Si cap. The curves show the difference in concentration and depth for an RTO step having varied oxygen concentration of 200 ppm, 400 ppm, 700 ppm, 1000 ppm and 4000 ppm. A curve is also shown for an anneal of the silicon capped substrate without oxygen, which resulted in no significant silicon doping. As can be seen, at a silicon concentration of about $10^{18}$ $cm^{-3}$, the depth of silicon diffusion increased from about 75 nm at 200 ppm $O_2$ to about 140 nm at 4000 ppm $O_2$. Similarly, at a silicon depth of about 100 nm, the silicon concentration increased from about $7x10^{17}$ $cm^{-3}$ at 200 ppm $O_2$, to about

$2x10^{19}$ $cm^{-3}$ at 4000 ppm $O_2$.

Fig. 5 is a set of atomic Si concentration versus diffusion depth curves illustrating control of Si diffusion depth as well concentration by varying the diffusion time at 950° C for a Si cap of 50 nm and oxygen content of 1000 ppm during RTO. The time was varied at 10, 20 and 60 seconds. Fig. 6 is a set of atomic Si concentration versus diffusion depth curves illustrating control of Si diffusion depth as well concentration by varying the diffusion time at 1000° C for a Si cap of 160 nm and oxygen content of 1000 ppm during RTO. The time was varied at 5, 10 and 30 seconds. As can be seen from Figs. 4, 5 and 6, the present invention provides a wide range of control of the depth and concentration of the silicon doping of III-V compounds.

The method of the present invention for silicon doping of III-V compounds may be useful in the fabrication of various semiconductor devices. One of the more common devices using III-V materials is the metal semiconductor field effect transistor (MESFET). The silicon doping methods described herein may be used to form the channel region of a MESFET where the source and drain regions are formed by other known techniques such as icn implantation. Alternately, the methods of the invention may be used to form the source and drain regions with the channel being formed by other known techniques. Finally, all three regions, the source, drain and channel may be formed using the inventive methods. In addition, the silicon doping process may be used to form enhancement mode or depletion mode devices.

Turning now to Figs. 7a - 7d, there is shown a method for forming a MESFET in which the processes of the present invention are used to form the source, drain and channel regions. In a first step, as shown in Fig. 7a, a very shallow diffusion layer 20 is formed in a III-V substrate 21 in accordance with the methods of the present invention described above. Portions of the layer 20 will act as the channel region for the MESFET. The silicon capping layer 22 is then removed by reactive ion etching and metal gates 24, as shown in Fig. 7b, are then deposited using conventional photolithographic or selective deposition techniques. The gates may be any suitable material such as a refractory metal and they may be formed with or without insulating sidewalls. A conformal layer of silicon 26 is then deposited on the substrate 22 and gates 24. Depending on the gate material, a thin layer of $SiO_2$ or other dielectric may be required between the gate and Si cap to prevent any undesirable reaction between the cap and the gate during RTO.

Thereafter, as shown in Fig. 7c, the wafer is subjected to a second thermal oxidation step in accordance with the present invention thereby forming silicon diffusion regions 30 in the substrate 21 in the areas between the gates 24. Subsequently, the silicon layer 26 is removed either chemically or by reactive ion etching, in the latter case silicon gate sidewalls 32, as shown in Fig. 7d are formed. Thus, self-aligned source and drain regions 30 are formed.

Ohmic contacts are then deposited on the source and drain regicns 30 to complete the MESFET. In one embodiment, the ohmic contacts are formed before removal of the silicon cap layer. In this embodiment, the silicon layer above the gates 24 is selectively removed. A metal such as nickel, cobalt, titanium, or other suitable metal is deposited on the silicon between the gates. Thereafter, the silicon/metal bilayer is subjected to a low temperature anneal that provides a low resistivity contact to the underlying source and drain regions. This method of forming the ohmic contacts will be enhanced where the silicon is doped with arsenic or phosphorus prior to oxidation.

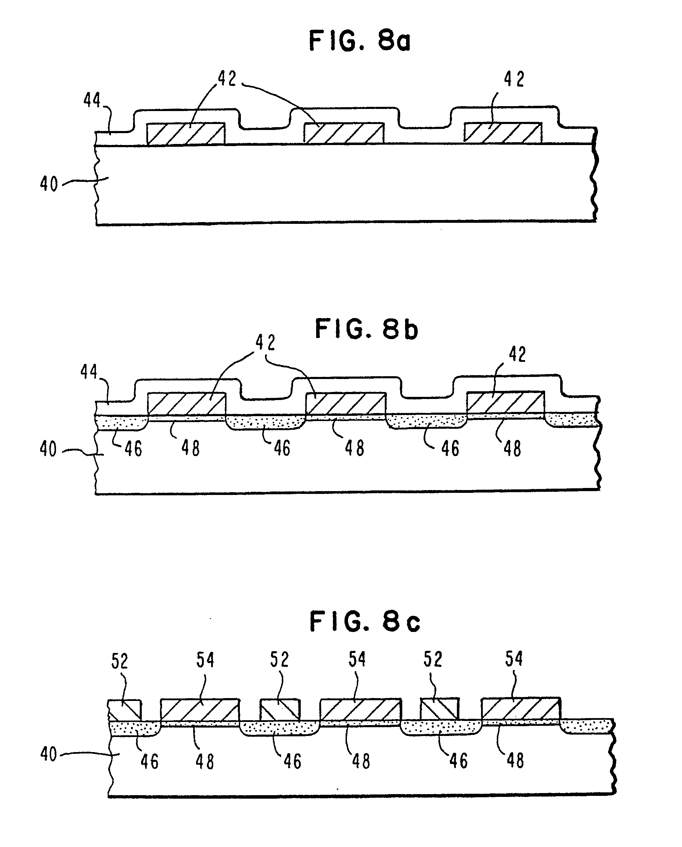

In an alternative embodiment, the source, drain and channel regions are diffused in a single oxidation step. Referring to Fig. 8a, a substrate 40 of a III-V compound is provided and suitable dielectric pads 42, such as silicon oxinitride, are deposited on the substrate by conventional masking and etching techniques. The material forming the pads must not be a barrier to silicon diffusion but must reduce silicon diffusion through the material. A silicon layer 44 is then deposited on the substrate and the silicon oxinitride pads. Thereafter, the substrate is subjected to the thermal oxidation step which results in silicon diffusing into the substrate tc form source and drain regions 46 and channel regions 48 as shown in Fig. 8b. The silicon above the pads 42 must diffuse through the pads thereby providing a very shallow channel region with respect to the source and drain regions that diffuse directly from the silicon. As shown in Fig. 5c, after the silicon layer 44 is removed, ohmic contacts 52 are formed to the source and drain regions 46 and gate regions 54 are formed by applying advanced photolithography techniques to provide tight alignment tolerances.

The present invention provides a simple yet powerful method to achieve controlled shallow silicon doping in III-V compounds by depositing a silicon cap layer on the III-V substrate followed by a thermal oxidation treatment. A subsequent annealing treatment enhances the electrical characteristics of the doped region. High electron concentration amounts in the range of $10^{19}$ $cm^{-3}$ and low resistivities the range of less than 50 Ω/□ can be achieved for shallow regions of 200 nm or less.

While the invention has been particularly shown and described with respect to the preferred embodiments thereof, it should be understood by those skilled in the art that the foregoing and other changes in form and detail may be made therein without departing from the spirit and scope of the invention.

## Claims

1. A method of fabricating a semiconductor device comprising the steps of:

   depositing a layer of silicon (12) on a surface of a semiconductor substrate (10) of a III-V compound; and

   thermally oxidizing said silicon layer (12) thereby diffusing silicon into at least a portion of said substrate (10).

2. The method of claim 1 wherein said silicon (12) depositing step and said thermal oxidizing step are performed in situ.

3. The method of claim 1 or 2 wherein said silicon (12) is deposited to a thickness of about 10 nm or greater.

4. The method of one or more of the preceding claims 1 to 3 wherein said silicon is diffused into said substrate (10) to a thickness of about 20 nm or greater with an electron concentration that can be varied up to about $1x10^{19}$ $cm^{-3}$.

5. The method of one or more of the preceding claims 1 to 4 wherein said thermal oxidizing step is performed in an atmosphere of one of pure $O_2$, dry air, steam and diluted $O_2$ in an inert carrier gas, preferably the oxidizing atmosphere is diluted $O_2$ in Ar having a oxygen concentration of about 200 ppm or greater.

6. The method of one or more of the preceding claims 1 to 5 wherein said thermal oxidizing step is performed at a temperature in the range of about 500 to 1100 $^{\circ}$ C.

7. The method of one or more of the preceding claims 1 to 6 wherein the oxidizing step is performed by rapid thermal oxidation.

8. The method of one or more of the preceding claims 1 to 7 further including the step of annealing said substrate (10) subsequent to said thermal oxidizing step sufficient to cause at least a portion of said substrate (10) having the diffused silicon (14) to have a sheet resistance lower than the sheet resistance of said portion after the thermal oxidizing step.

9. The method of claim 8 wherein the sheet resistance of said at least a portion of said substrate (10) having the diffused silicon (14) is less than 50 Ω/□ , preferably about 25 Ω/□ or less.

10. The method of claim 8 or 9 wherein said annealing step is performed by rapid thermal annealing.

11. The method of one or more of the preceding claims 8 to 10 wherein said annealing step is performed in an inert atmosphere at a temperature of about 600 $^{\circ}$ C or greater.

12. The method of one or more of the preceding claims 8 to 11 wherein said thermal oxidation step and said annealing step are performed in situ.

13. The method of one or more of the preceding claims 8 to 12 wherein said thermal oxidizing step is performed under oxidizing conditions including type of oxygen ambient, amount of oxygen in the ambient, temperature and time of said step and wherein said annealing step is performed under annealing conditions including type of ambient, temperature and time and further including the step of controlling the sheet resistance and depth of the diffused silicon (14) by controlling the thickness of said silicon (14), the oxidizing conditions and the annealing conditions.

14. The method of one or more of the preceding claims 1 to 13, further including the step of depositing a barrier layer (18) on said III-V compound substrate (10) prior to the deposition of said silicon layer (12).

15. The method of claim 14 wherein said barrier layer (18) is comprised of one of silicon nitride and aluminum oxide.

16. The method of one or more of the preceding claims 1 to 15 further including the step of doping said silicon layer (12) prior to the thermal oxidizing step with one of phosphorus, arsenic and boron.

17. The method of one or more of the preceding claims 1 to 16 further including the step of forming an ohmic contact to the at least a portion of said substrate (10) having the silicon diffusion (14) by removing the oxide layer, depositing a layer of metal on the silicon layer (12) and annealing the silicon (12) and metal layers to provide a low resistivity contact to the portion of the substrate (10) having the diffused silicon (14) therein.

18. A method for forming a MESFET comprising the steps of:

depositing a first layer of silicon (22) on a surface of a semiconductor substrate (21) of a III-V compound;

thermally oxidizing said first silicon layer (22) thereby diffusing silicon into at least a portion of said substrate (21) at temperatures and oxidizing conditions to form a shallow channel diffusion region (20);

removing said silicon layer;

depositing at least one metal gate (24) on the substrate (21);

depositing a second layer of silicon (26) on the substrate (21) and said at least one metal gate (24);

thermally oxidizing said second silicon layer (26) thereby diffusing silicon into said substrate (21) adjacent said at least one metal gate (24) at temperatures and oxidizing conditions to form silicon diffusion source and drain regions (30); and

removing said second silicon layer (26) forming ohmic contacts to said source and drain regions (30).

19. A method for forming a MESFET comprising the steps of:

depositing at least one pad of silicon oxinitride (42) on the surface of a semiconductor substrate (40) of a III-V compound;

depositing a conformal layer of silicon (44) on the surface of said substrate (40) and said pads (42);

thermally oxidizing said silicon layer (44) thereby diffusing silicon into said substrate (40) at temperatures and oxidizing conditions to form a channel region (48) below said at least one pad (42) and source and drain regions (46) adjacent said pad (42);

removing said silicon layer (44) and said at least one pad (42);

depositing a gate region (54) on the substrate (40) above said channel region (48); and

forming ohmic contacts (52) to said source and drain regions (46).

20. A semiconductor device comprising a semiconductor substrate of a III-V compound having therein at least one silicon doped region having a sheet resistance of less than 50 Ω/□ , an electron concentration of greater than $6x10^{18}$ $cm^{-3}$ and a depth of about 0.2 $\mu$m or less, including a contact attached to said at least one silicon doped region, said contact including a layer of silicon disposed on said at least one silicon doped region and a layer of a metal disposed on said silicon.

FIG. 1a

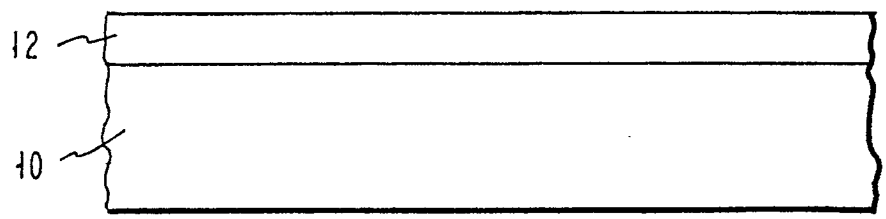


FIG. 1b

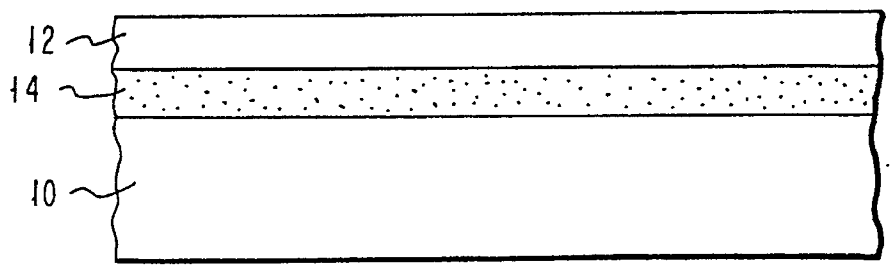


FIG. 1c

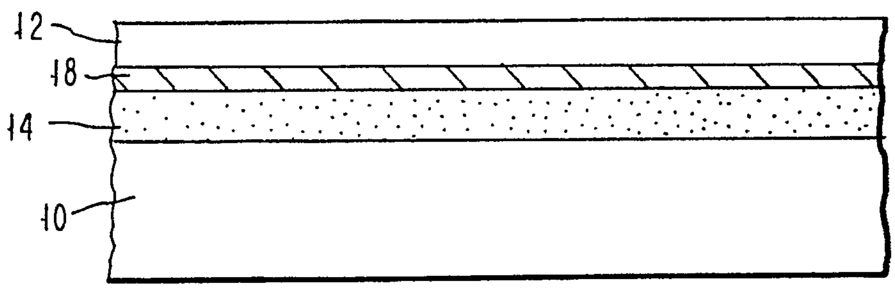


FIG. 1d

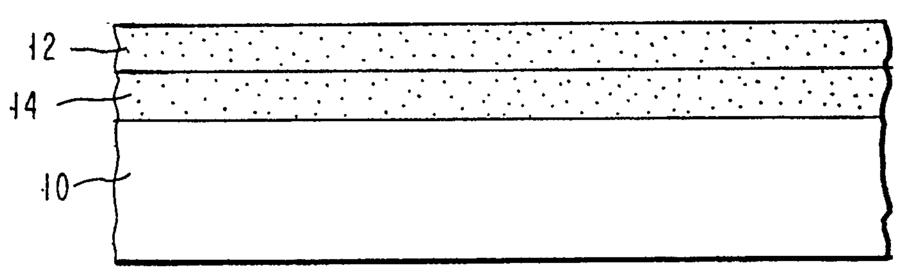

FIG. 2

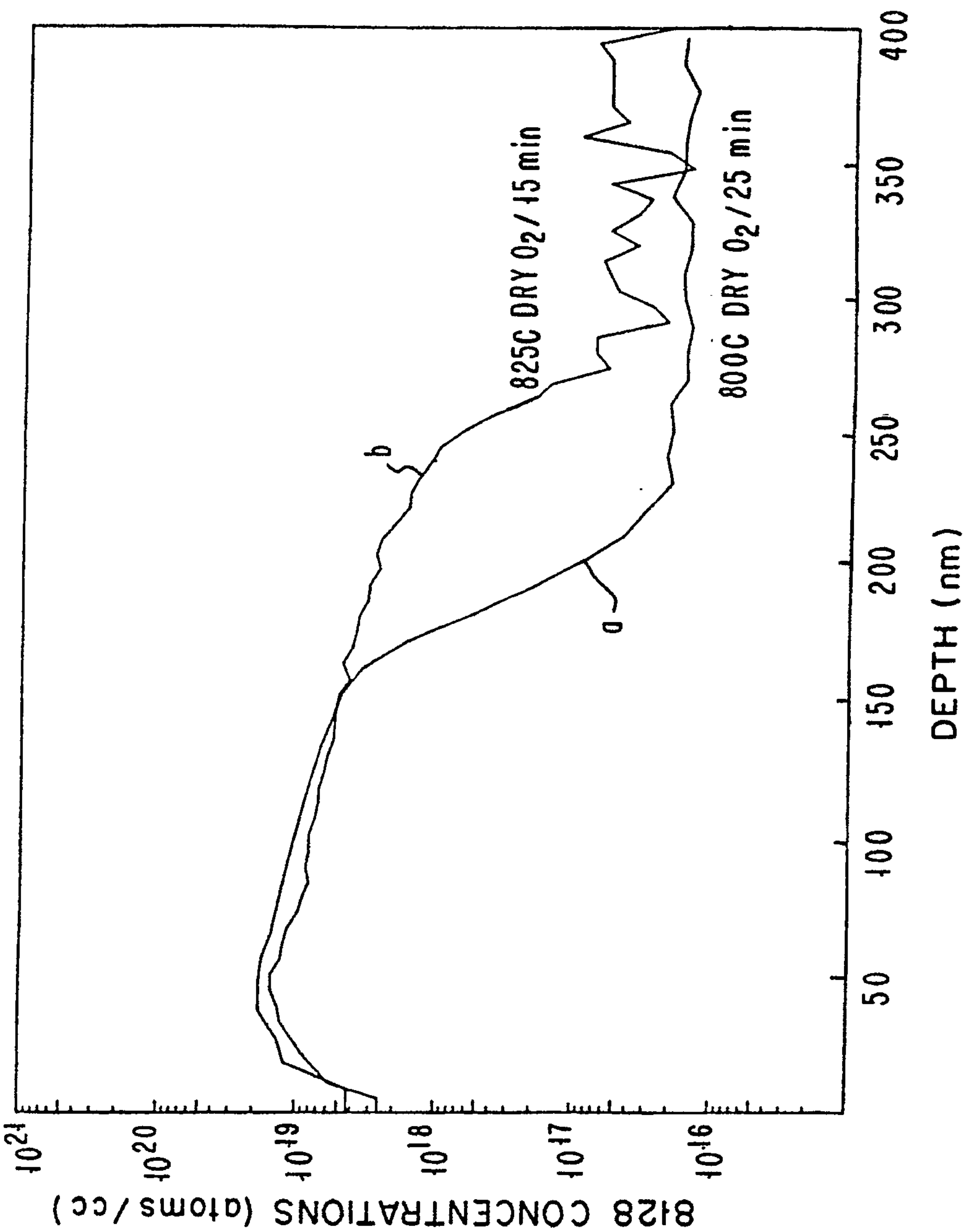
825C DRY $O_2$ / 45 min
800C DRY $O_2$ / 25 min
a
b
DEPTH (nm)
50
100
150
200
250
300
350
400
B128 CONCENTRATIONS (atoms/cc)
$10^{21}$
$10^{20}$
$10^{19}$
$10^{18}$
$10^{17}$
$10^{16}$

FIG. 3

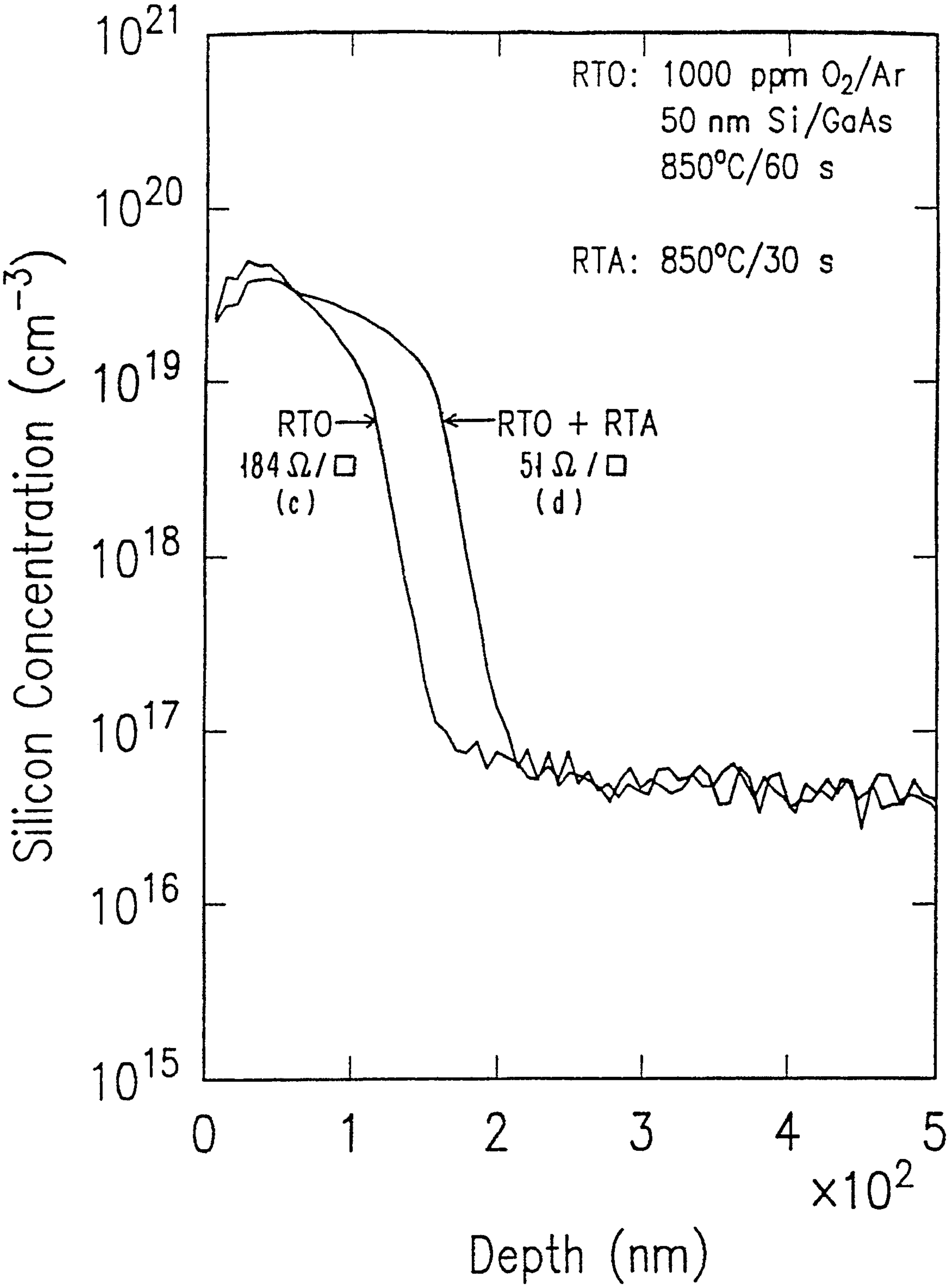
RTO: 1000 ppm O2/Ar
50 nm Si/GaAs
850°C/60 s
RTA: 850°C/30 s
RTO
184 Ω/□
(c)
RTO + RTA
51 Ω/□
(d)
Silicon Concentration (cm-3)
10^21
10^20
10^19
10^18
10^17
10^16
10^15
0
1
2
3
4
5
x10^2
Depth (nm)

FIG. 4

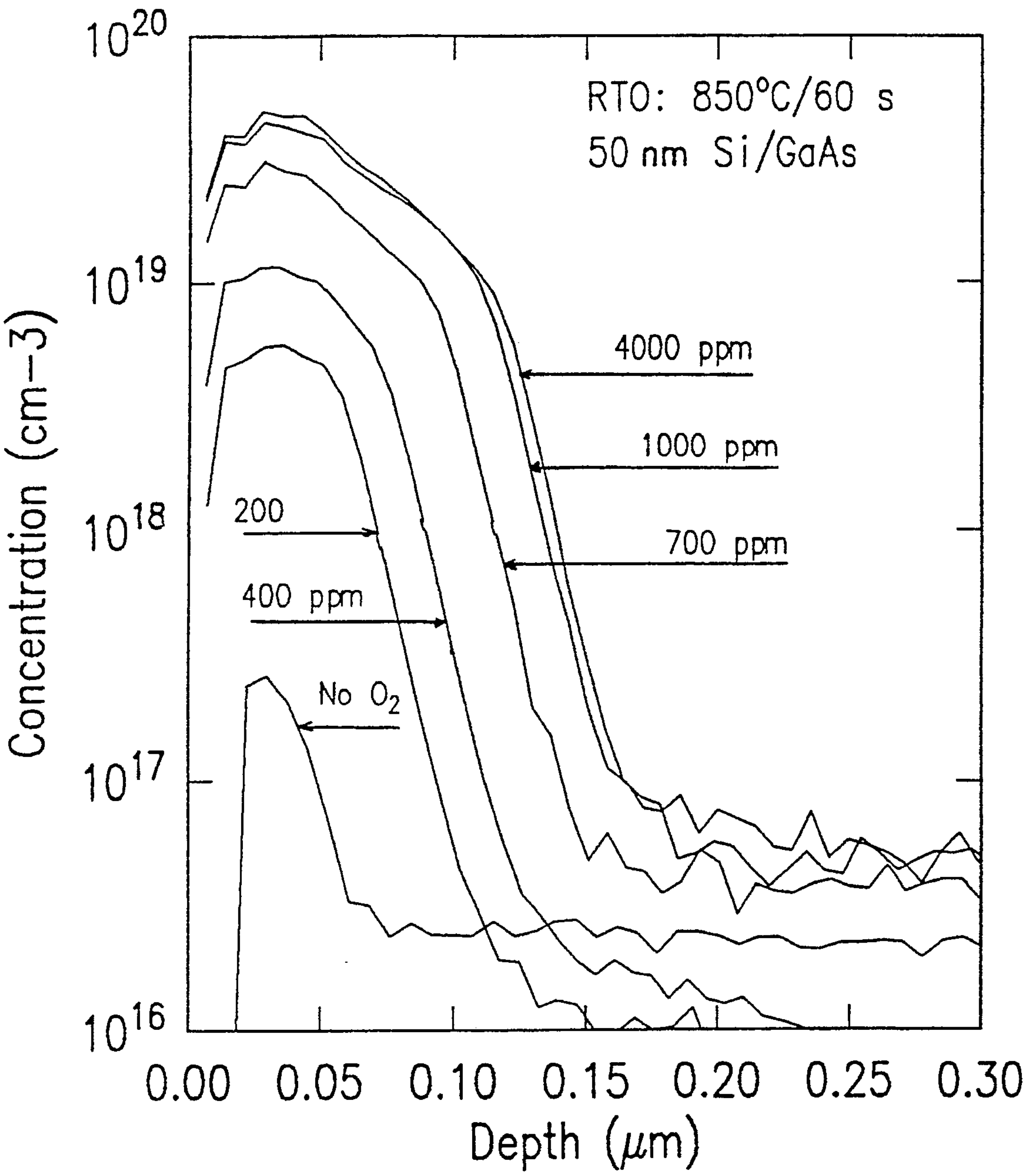
RTO: 850°C/60 s
50 nm Si/GaAs
4000 ppm
1000 ppm
700 ppm
200
400 ppm
No O2
Concentration (cm−3)
10^20
10^19
10^18
10^17
10^16
0.00
0.05
0.10
0.15
0.20
0.25
0.30
Depth (μm)

FIG. 5

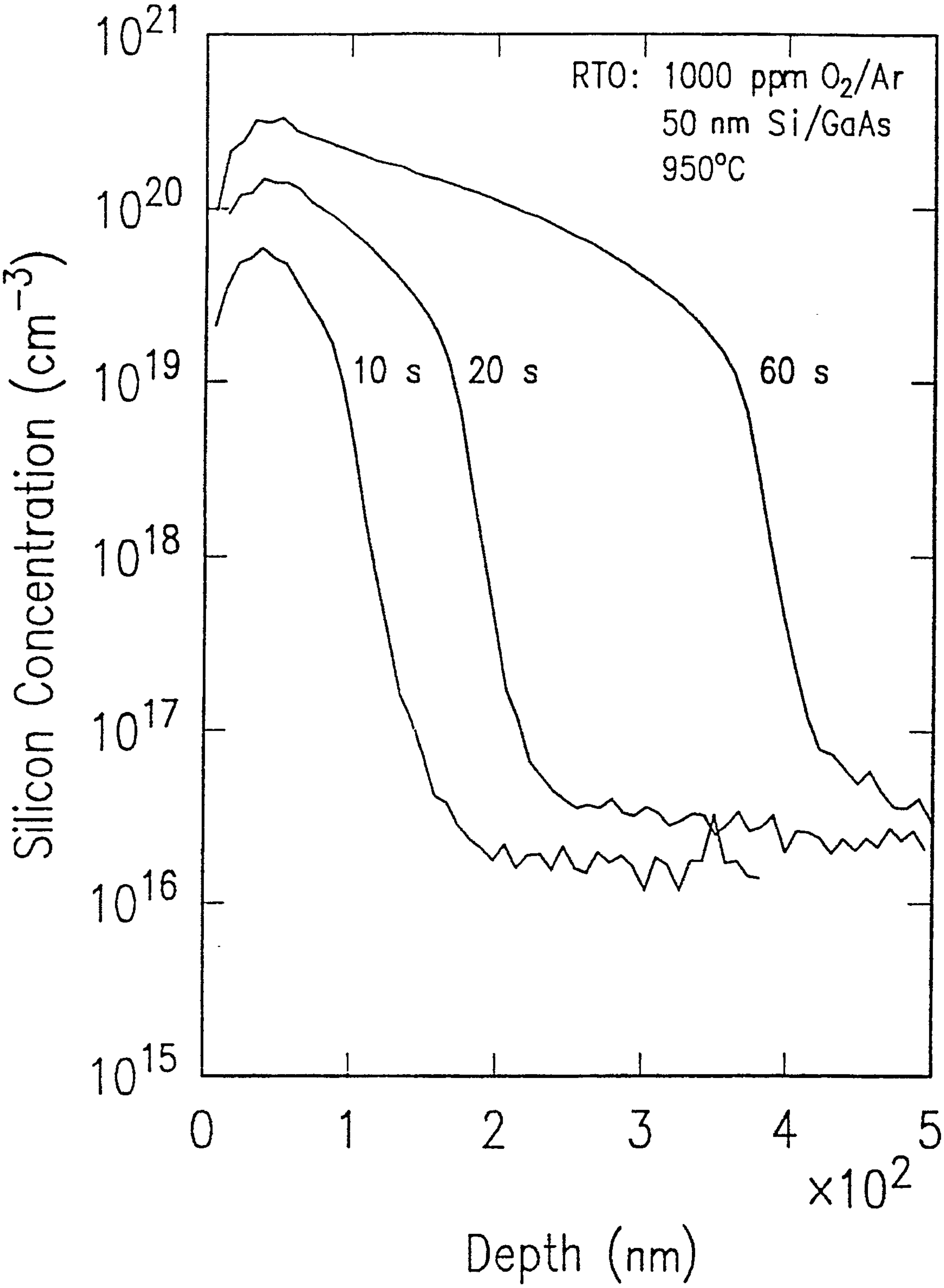
RTO: 1000 ppm O2/Ar
50 nm Si/GaAs
950°C
10 s
20 s
60 s
Silicon Concentration (cm-3)
10^21
10^20
10^19
10^18
10^17
10^16
10^15
0
1
2
3
4
5
x10^2
Depth (nm)

FIG. 6

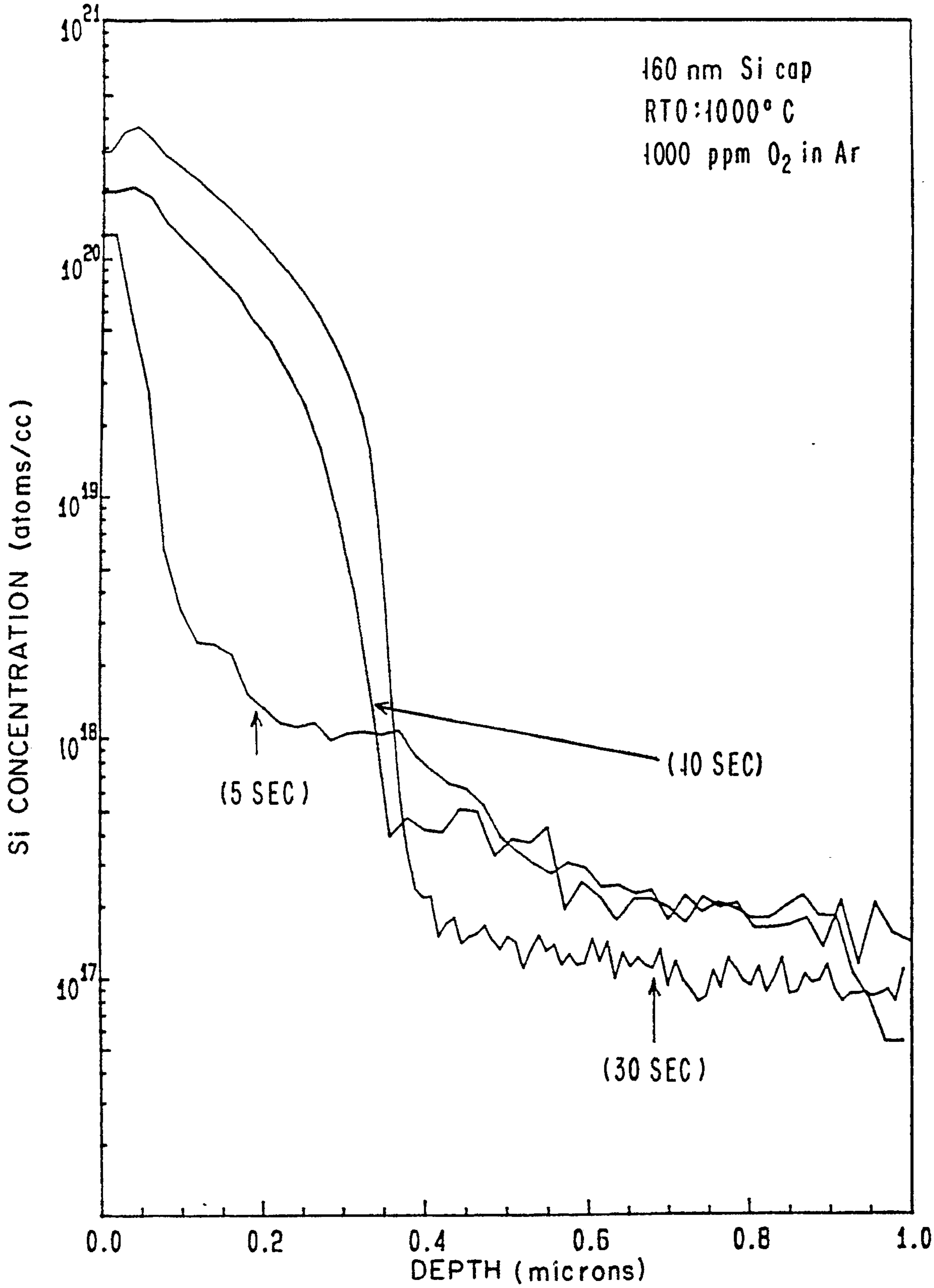
160 nm Si cap
RTO:1000° C
1000 ppm $O_2$ in Ar
(5 SEC)
(10 SEC)
(30 SEC)
$10^{21}$
$10^{20}$
$10^{19}$
$10^{18}$
$10^{17}$
Si CONCENTRATION (atoms/cc)
0.0
0.2
0.4
0.6
0.8
1.0
DEPTH (microns)

FIG. 7a

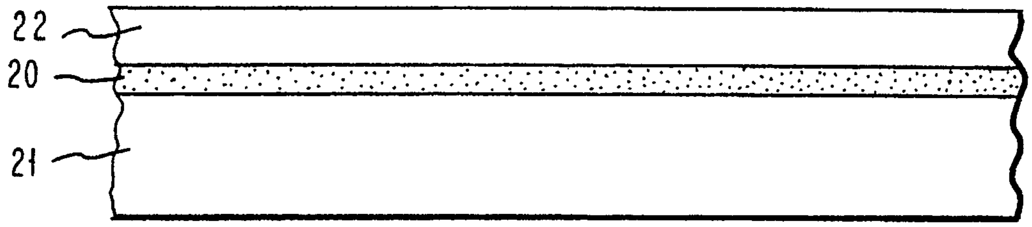


FIG. 7b

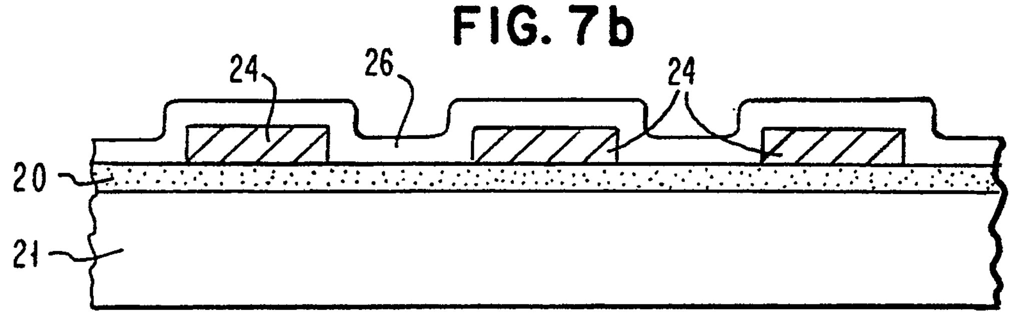


FIG. 7c

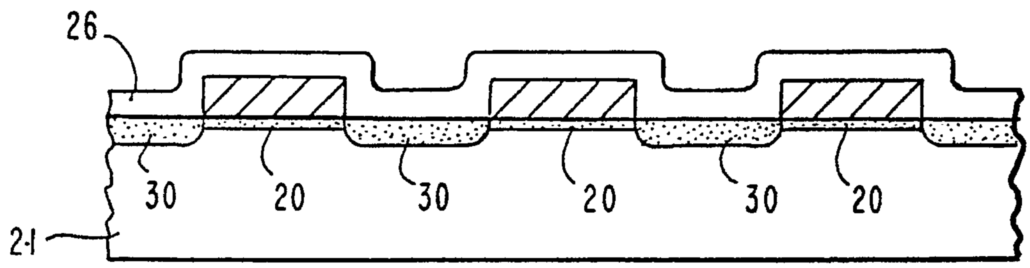


FIG. 7d

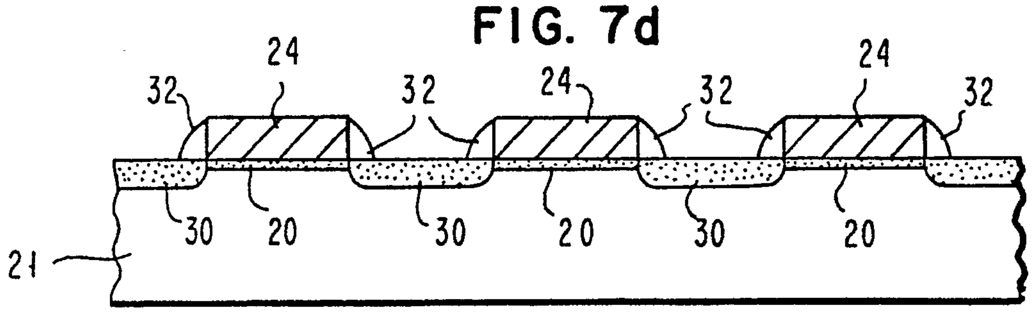

FIG. 8a

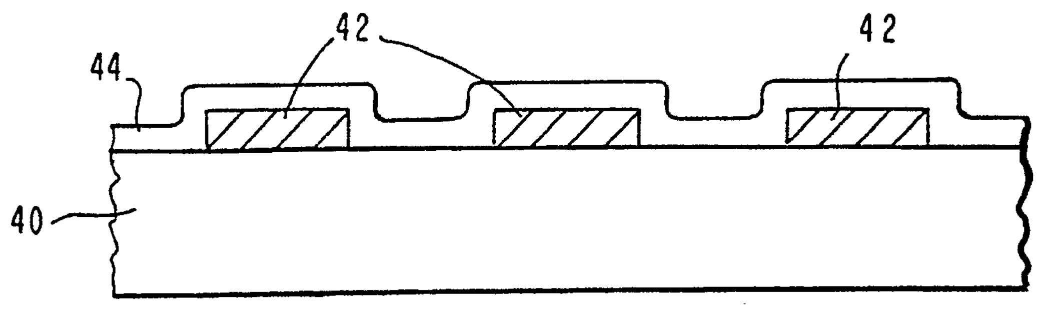


FIG. 8b

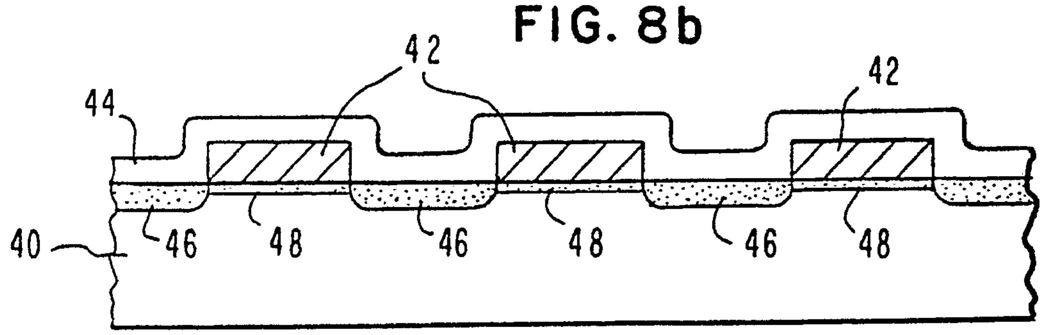


FIG. 8c